# EUROPEAN PATENT APPLICATION

(11) **EP 4 446 480 A1**
(43) Date of publication of application: **16.10.2024**
(21) Application number: 22904291.6
(22) Date of filing: 08.12.2022
(51) Int. Cl.: C30B 33/04, C01B 32/28

(54) **VOID DEFECT FORMING METHOD, DEVICE, AND DIAMOND MANUFACTURING METHOD**

(30) Priority: 09.12.2021 JP 2021199843
(71) Applicant: Kyoto University, Kyoto-shi, Kyoto 606-8501 (JP)
(72) Inventor: MIZUOCHI, Norikazu, Kyoto-shi, Kyoto 606-8501 (JP); FUJIWARA, Masanori, Kyoto-shi, Kyoto 606-8501 (JP); HASHIDA, Masaki, Kyoto-shi, Kyoto 606-8501 (JP); INOUE, Shunsuke, Kyoto-shi, Kyoto 606-8501 (JP); MASUNO, Shin-ichiro, Kyoto-shi, Kyoto 606-8501 (JP)
(74) Representative: Studio Torta S.p.A.
(86) International application number: PCT/JP2022/045265
(87) International publication number: WO 2023/106363

(57) **Abstract**

Provided is a method for forming a vacancy defect in diamond, including the step of concentrating pulsed light from a pulsed laser to irradiate the diamond with the pulsed light, wherein the fluence of the pulsed laser in a focal region on the diamond is 1.8 J·cm⁻² or more.

## Description

### Technical Field

The present invention relates to a method for forming a vacancy defect in diamond, a device therefor, and a method for producing diamond with a vacancy defect.

### Background Art

Due to its excellent optical, electrical, and thermal properties, diamond is expected to find applications in optical elements and electronic devices. In particular, the nitrogen-vacancy center, known as NV center, which exists inside diamond, has attracted much attention. The NV center is composed of a pair of nitrogen impurity inside the diamond and an adjacent vacancy defect, and exhibits magnetic properties called "electron spin" when electrons are captured in the vacancy. Because the electron spin in the NV center has a long coherence time even at room temperature, and the spin state is controllable and detectable at room temperature, diamond shows promise for application in quantum computing and highly sensitive quantum sensors, for example, for magnetic and electric fields.

Recent studies report that the NV center is formed in diamond by using a femtosecond laser, as disclosed in PTL 1 listed below.

### Citation List

### Patent Literature

PTL 1: JP2021-526498A

### Summary of Invention

### Technical Problem

An ensemble of NV centers, which is a collection of many NV centers, is vital for application of diamond in quantum computing. Ensembles of NV centers have an advantage in achieving improved performance of quantum sensors due to their increased signal intensity. If an ensemble of NV centers is an assembly of four differently oriented NV centers, such an ensemble is advantageous in its capability of determining the 3D vector components of a magnetic field by using the differences in Zeeman splitting width due to their different orientation. In applications of diamond in quantum sensors, forming numerous NV centers in diamond (an ensemble of NV centers) to increase the concentration of NV centers is thus effective in improving the measurement sensitivity of sensors.

The method disclosed in PTL 1 is a technique for forming NV centers so as to map them in a desired pattern within the crystal lattice of diamond. The method disclosed in PTL 1 does not desirably increase the temporal formation efficiency or yield in the formation of NV centers, nor does it desirably increase the concentration of NV centers. To apply NV centers of diamond in, for example, quantum sensors, a technique of efficiently forming diamond vacancy defects in diamond is required.

An object of the present invention is to efficiently form vacancy defects in diamond.

### Solution to Problem

The present invention to achieve the object includes, for example, the following aspects.

### Item 1.

A method for forming a vacancy defect in diamond, comprising the step of concentrating pulsed light from a pulsed laser to irradiate the diamond with the pulsed light,
wherein a fluence of the pulsed laser in a focal region on the diamond is 1.8 J·cm⁻² or more.

### Item 2.

The method according to Item 1, wherein in the step of concentrating pulsed light from a pulsed laser to irradiate the diamond with the pulsed light, the diamond is repeatedly irradiated with one to four shots of a single beam of the pulsed light per cycle.

### Item 3.

The method according to Item 1 or 2, wherein the fluence of the pulsed laser is 54 J·cm⁻² or less.

### Item 4.

The method according to any one of Items 1 to 3, wherein the focal region has an area of 175 µm² or more.

### Item 5.

The method according to any one of Items 1 to 4, further comprising the step of controlling a shape of the focal region.

### Item 6.

The method according to any one of Items 1 to 5, wherein the fluence of the pulsed laser is 5.1 J·cm⁻² or more. Item 7.

The method according to any one of Items 1 to 6, wherein
the fluence of the pulsed laser is 9.6 J·cm⁻² or more, and
the step of concentrating pulsed light from a pulsed laser to irradiate the diamond with the pulsed light is performed under a pressure in space surrounding the diamond lower than atmospheric pressure.

### Item 8.

An apparatus for forming a vacancy defect in diamond, comprising
a pulsed laser, and
an optical system configured to concentrate pulsed light from the pulsed laser to irradiate the diamond with the pulsed light,
wherein a fluence of the pulsed laser in a focal region on the diamond is 1.8 J·cm⁻² or more.

### Item 9.

The apparatus according to Item 7, wherein the optical system has an aperture configured to control a shape of the focal region.

### Item 10.

A method for producing diamond having a vacancy defect, comprising
the step of preparing diamond, and
the step of forming a vacancy defect in the diamond according to the method of any one of Items 1 to 7.

### Advantageous Effects of Invention

The present invention efficiently forms vacancy defects in diamond.

### Brief Description of Drawings

Fig. 1 shows a schematic structure of a vacancy defect formation apparatus according to an embodiment of the present invention.
Fig. 2 shows examples of laser spatial distribution in an irradiation site.
Fig. 3 shows a schematic structure of a measurement system used to evaluate vacancy defects formed in a sample.
Fig. 4 shows the results of evaluating NV centers formed in diamond in Example 1 according to various measurements.
Fig. 5 shows the results of measuring the dependence of fluence in Example 2.
Fig. 6 shows the state of a diamond substrate after NV centers were formed by varying the frequency of pulse irradiation in Example 3.
Fig. 7 shows fluorescence spectra of diamond graphitized in Example 3.
Fig. 8 shows fluorescence spectra of diamond graphitized in Example 3.
Fig. 9 shows the state of a diamond substrate after NV centers were formed in Example 5.
Fig. 10 shows a confocal image of diamond after NV centers were formed in Example 5, with the image superposed on the photograph of the diamond substrate shown in Fig. 9 so as to coincide with the photograph.
Fig. 11 shows the measurement results of fluorescence spectra taken for regions near the boundary of the focal region in Example 5.
Fig. 12 shows the measurement results of fluorescence spectra taken for regions near the center of the focal region in Example 5.
Fig. 13 shows the measurement results of fluorescence spectra taken for regions near the center of the focal region in Example 5.
Fig. 14 shows the measurement results of fluorescence spectra taken for regions near the boundary of the focal region in Example 5.
Fig. 15 shows the measurement results of fluorescence spectra taken for regions near the boundary of the focal region in Example 5.
Fig. 16 is a graph showing the results of examining the relationship between the size of a focal region and fluence in various kinds of pulse energy in Example 6.

### Description of Embodiments

The following describes in detail embodiments of the present invention with reference to attached drawings. In the following description and drawings, the same reference numerals indicate the same or similar component; therefore, redundant descriptions of the same or similar components will be omitted.

In the first aspect of the present invention, a method for forming a vacancy defect in diamond is provided. The method according to an embodiment comprises the step of concentrating pulsed light from a pulsed laser to irradiate diamond with the pulsed light, wherein the fluence of the pulsed laser in a focal region on the diamond is 1.8 J·cm⁻² or more. More preferably, the fluence of the pulsed laser is 54 J·cm⁻² or less. Still more preferably, the fluence of the pulsed laser is 5.1 J·cm⁻² or more.

In the method according to an embodiment, in the step of concentrating pulsed light to irradiate diamond with the pulsed light, the diamond is repeatedly irradiated with one to four shots of a single beam of the pulsed light per cycle. More preferably, diamond is irradiated with one shot of a single beam of pulsed light in the method.

In the method according to an embodiment, the focal region has an area of 175 µm² or more.

In the method according to an embodiment, the method further comprises the step of controlling the shape of the focal region. More preferably, the shape of the focal region is substantially elliptical.

In the second aspect of the present invention, an apparatus for forming a vacancy defect in diamond is provided. The apparatus according to an embodiment comprises a pulsed laser and an optical system configured to concentrate pulsed light from the pulsed laser to irradiate diamond with the pulsed light, wherein the fluence of the pulsed laser in a focal region on the diamond is 1.8 J·cm⁻² or more. More preferably, the fluence of the pulsed laser is 54 J·cm⁻² or less. Still more preferably, the fluence of the pulsed laser is 5.1 J·cm⁻² or more.

The apparatus according to an embodiment repeatedly irradiates diamond with one to four shots of a single beam of pulsed light per cycle. More preferably, the apparatus irradiates diamond with one short of a single beam of pulsed light.

In the apparatus according to an embodiment, the optical system has an aperture configured to control the shape of the focal region. More preferably, the shape of the focal region is substantially elliptical.

In the third aspect of the present invention, a method for producing diamond having a vacancy defect is provided. The method according to an embodiment comprises the step of preparing diamond and the step of forming a vacancy defect in the diamond according to the method provided in the first aspect of the present invention.

### Vacancy Defect Formation Apparatus

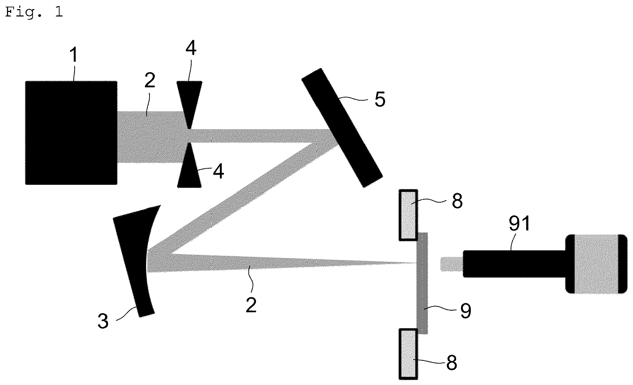

Fig. 1 shows a schematic structure of a vacancy defect formation apparatus according to an embodiment of the present invention. A method for forming a vacancy defect according to an embodiment is enabled by using a vacancy defect formation apparatus 10, described below with reference to Fig. 1.

The vacancy defect formation apparatus 10 according to an embodiment mainly comprises a laser 1 for use as an optical source configured to modify a sample 9 and a light-collecting element 3 configured to collect pulsed light 2 emitted from the laser 1 and irradiate the sample 9 with the pulsed light 2. The pulsed light 2 emitted from the laser 1 has its focus diameter controlled in at least either the vertical direction or the horizontal direction, or both directions on the plane perpendicular to the travelling direction of the pulsed light 2 due to an aperture 4 placed in the light path. The travelling direction of the pulsed light 2 is adjusted by a total-reflection mirror 5, and the pulsed light 2 is condensed by the light-collecting element 3. Then, the sample 9 placed on a stage 8 is irradiated with the pulsed light 2. The sample 9 is modified by the irradiation with the pulsed light 2, and vacancy defects are formed in the sample 9. The aperture 4, total-reflection mirror 5, and stage 8 are optional elements.

In this embodiment, the sample 9 is subjected to convergent beam irradiation with the pulsed light 2 under the condition that the fluence of the laser 1 at a focal region (laser spot) on the sample 9 is about 1.8 J·cm⁻² or more and about 54 J·cm⁻² or less. "Fluence" indicates the degree of light collection and is expressed in terms of energy per unit area.

The vacancy defect formation apparatus 10 may further comprise a beam profiler 91 as an optional element for measuring the profile of laser light at an irradiation site. For example, the beam profiler 91 may be a CCD camera.

Various types of diamond may be used for the sample 9. In this embodiment, the sample 9 is, for example, an HPHT type-Ib single-crystalline synthetic diamond with a high concentration of nitrogen impurities and is [001]-oriented. By way of example, the nitrogen concentration of synthetic diamond used as the sample 9 is about 100 ppm. The sample 9 is placed on the 3-axis stage 8. The region of the sample 9 on which the pulsed light 2 is emitted (X-Y plane) and the position of the sample 9 along the irradiation axis of the pulsed light 2 (Z axis) are adjustable. The sample 9 can be irradiated with the pulsed light 2 at room temperature in the atmosphere. By way of example, room temperature means, but is not limited to, a temperature range of about 1°C to 30°C, including the normal temperature range of about 15°C to 25°C.

The laser 1 outputs the pulsed light 2 at a pulse width on the temporal order of femtoseconds (10⁻¹⁵ seconds). To achieve the output of high-intensity laser light with an extremely short pulse on the order of femtoseconds, the present embodiment uses the chirped pulse amplification (CPA) method for the laser 1, in which the pulse width is stretched, and the laser is amplified, followed by compressing the pulse width. The pulse compressor may contain various optical devices or optical elements to shorten the pulse width of the laser. Examples of such optical devices or optical elements include grating pairs, prism pairs, and chirped mirrors. The laser apparatus 1 according to this embodiment can compress the pulse width to about 35 femtoseconds (fs) by using a grating pair.

In the present embodiment, the pulsed light 2 is linearly polarized to s-polarized light or p-polarized light. The laser 1 for use is a titanium-sapphire laser that outputs pulsed light with a center wavelength of about 800 nm (regenerative amplifier). The laser 1 has a pulse width of about 35 femtoseconds (fs) in full width at half maximum (FWHM) of the intensity autocorrelation waveform and has a pulse energy of about 0.4 J. In other words, the peak power, which represents energy per unit time, of the laser 1 is about 1 × 10¹³W. Because the laser 1 can concentrate light to a diameter of about 3 µm, the maximum electric field amplitude corresponding to the intensity of this peak power is about 3.2 × 10¹³V/m. The contrast of the laser 1 is about 10¹¹, and the energy stability is about 2%. The peak power increases with a decrease in pulse width.

The pulsed light 2 output from the laser 1 has a wavelength transparent with respect to the absorption wavelength of the sample 9. This allows the laser 1 to modify the sample 9 in the vicinity of the focus point of the laser due to nonlinear absorption. The pulsed light 2 having a wavelength transparent with respect to the absorption wavelength of the sample 9 means that the pulsed light 2 has such a wavelength band that no spectral line appears in the absorption spectrum of the sample 9 even when the sample 9 is irradiated with the pulsed light 2. The energy of the pulsed light 2 emitted to the sample 9 is absorbed nonlinearly by the crystal lattice of the sample 9.

The light-collecting element 3, aperture 4, and total-reflection mirror 5 constitute an optical system for applying convergent beam irradiation to the sample 9 with the pulsed light 2. In this embodiment, a parabolic mirror is used for the light-collecting element 3, and gold is deposited on the surface of the total-reflection mirror 5. The aperture 4 is placed on the optical path and controls the focus diameter of the pulsed light 2 emitted from the laser 1 in at least either the vertical direction or the horizontal direction, or both directions. The spatial distribution of laser light at an irradiation site is controlled by the aperture 4. The aperture 4 can be referred to as an "aperture for space control."

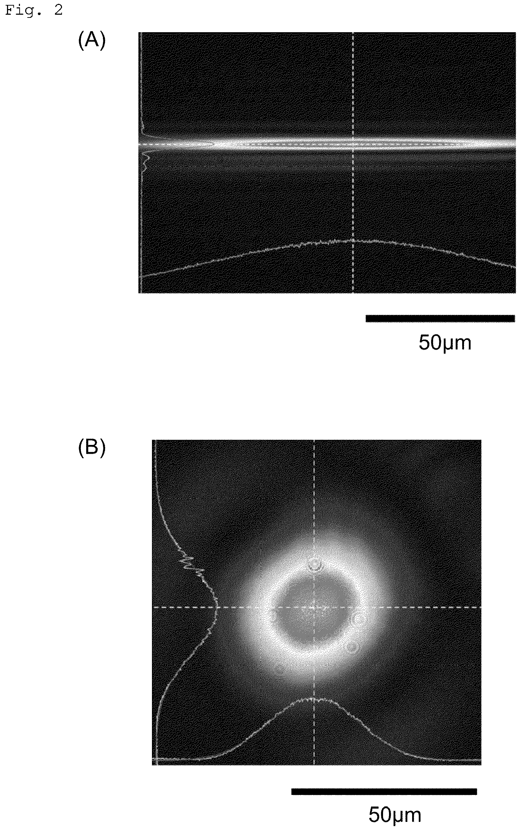

Fig. 2 shows examples of spatial distribution of laser at an irradiation site. Fig. 2(A) shows a laser profile for laser light with a substantially elliptical focal region. Fig. 2(B) shows a laser profile for laser light with a substantially circular focal region. The images of these spatial distributions shown in Fig. 2 can be captured by the beam profiler 91 shown in Fig. 1.

In the present embodiment, controlling the size of the aperture 4 in at least either the vertical direction or the horizontal direction, or both directions on the plane perpendicular to the travelling direction of the pulsed light 2 enables the pulsed light 2 to focus on the sample 9 such that the spot region has a substantially elliptical or circular shape. By way of example, if the focal region has a horizontally elongated, substantially elliptical shape as shown in Fig. 2(A), the dimensions of the focal region are about 2.5 um in the vertical direction and about 89 um in the horizontal direction, with the area of the focal region being about 175 µm². If the focal region has a substantially circular shape as shown in Fig. 2(B), the diameter of the focal region is about 24 um, and the area of the focal region is about 452 µm². The dimensions of the focal region (laser spot) shown in Fig. 2(A) and Fig. 2(B) are those of full width at half maximum (FWHM).

### Measurement System for Use in Evaluation

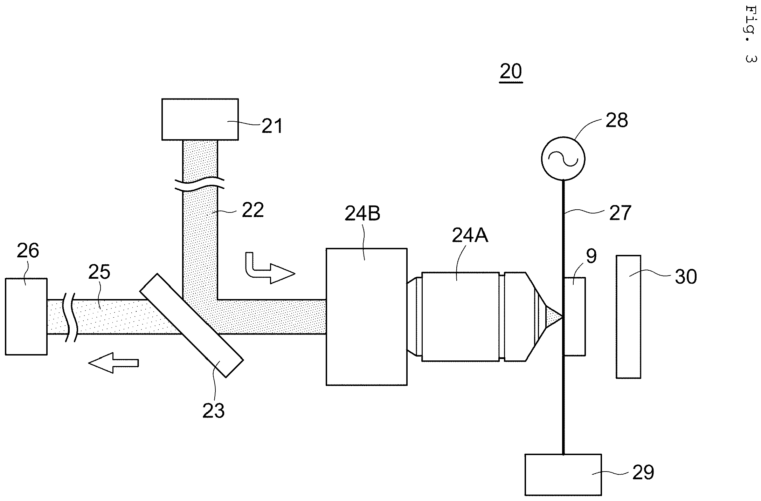

Fig. 3 shows a schematic structure of a measurement system used to evaluate vacancy defects formed in a sample.

The vacancy defects formed in the sample 9 can be evaluated according to the known optically detected magnetic resonance (ODMR) method using a measurement system 20 shown in Fig. 3. By way of example, the measurement system 20 can be made by using a known confocal fluorescence microscope.

In performing measurement according to the optically detected magnetic resonance (ODMR) method, a static magnetic field of about 30 gauss is applied to the sample 9 by using a magnet 30 to define a quantization axis. Excitation light 22 output from an excitation light source 21 is used to cause the NV center to transition from a ground state to an excited state, and is laser light with a wavelength of 532 nm (green). The excitation light 22 is reflected by a dichroic mirror 23 and collected by an objective lens 24A; then, the sample 9 is irradiated with the excitation light 22. If an NV center is present in the sample 9, the NV center in a ground state transitions into an excited state and then relaxes to a ground state. When relaxing into a ground state, the NV center emits red fluorescence 25 with a wavelength of around 700 nm. The intensity of the emitted fluorescence 25 is measured by using a photodiode 26. Microwave MW is applied to the sample 9 from a microwave source 28 by using a copper wire 27 (diameter: 30 µm). The frequency of the microwave MW being swept is measured by using a microwave detector 29. The optically detected magnetic resonance (ODMR) method can detect a magnetic resonance signal as the point at which the red fluorescence intensity has changed when the microwave frequency is swept at around 2.87 GHz.

A confocal image of the sample 9 can be captured by using the photodiode 26. The position of the objective lens 24A is adjusted by a 3-axis piezoelectric stage 24B, and this enables convergent beam irradiation of the excitation light 22 to different positions on the sample 9.

Examples of the present invention are given below to further clarify the characteristics of the invention. Unless otherwise noted in the description of each Example, the diamond used for samples and measurement conditions for the laser, such as fluence and peak power, are the same between the Examples.

### Example 1

In Example 1, vacancy defects (NV centers) formed in diamond were evaluated according to various measurements. An HPHT type-Ib single-crystalline [001]-oriented synthetic diamond was used as a sample. The fluence of the laser was set to 20 J·cm⁻², and the peak power was set to 1.1 × 10¹³ W. The shape of the focal region (laser spot) at a laser irradiation site was substantially circular, and the frequency of pulse irradiation N was one (one shot) .

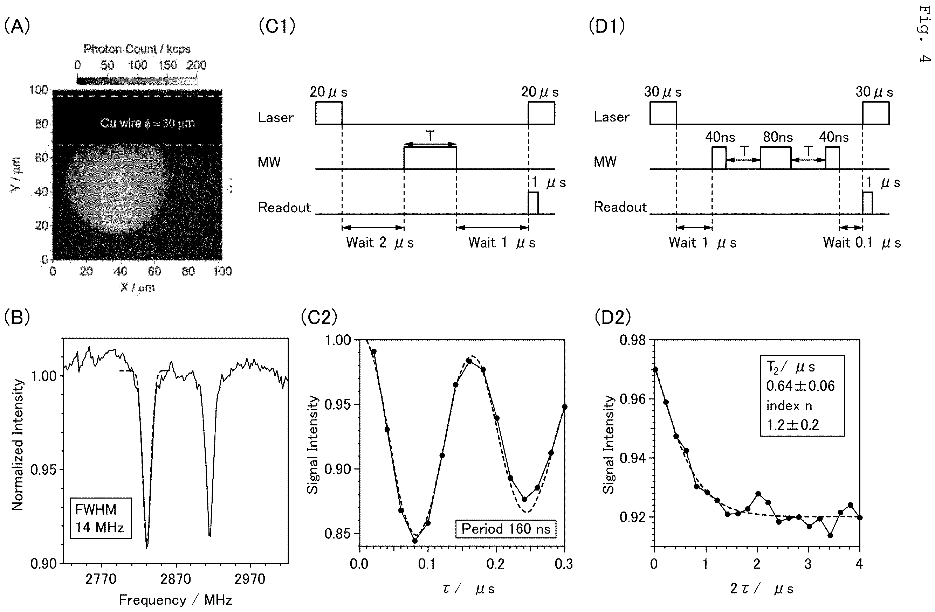

Fig. 4 shows the results of evaluating the NV centers formed in diamond in Example 1 according to various measurements. Fig. 4(A) shows a confocal image at a laser spot on diamond. Fig. 4(B) shows a magnetic resonance signal of NV centers measured according to the optically detected magnetic resonance (ODMR) method. Fig. 4(C1) and Fig. 4(C2) show the pulse sequence used in measuring Rabi and the measurement results. Fig. 4(D1) and Fig. 4(D2) show the pulse sequence used in measuring a spin echo (Hahn echo) and the measurement results.

The results of various measurements of NV centers shown in Fig. 4 were analyzed. As shown in Fig. 4(A), an increase in fluorescence intensity was confirmed at the area irradiated with a convergent beam of laser on diamond. As shown in Fig. 4(B), a magnetic resonance signal with a full width at half maximum of about 14 MHz was measured. As shown in Fig. 4(C2), a Rabi oscillation with a period of about 160 ns (nanoseconds) was measured. As shown in Fig. 4(D2), a transverse relaxation time (decoherence time) T₂ of about 0.64 ± 0.06 µs was measured.

The measurement results of Fig. 4 indicate that NV centers were formed at the region irradiated with a convergent beam of femtosecond pulsed laser on diamond.

### Example 2

In Example 2, the dependence of fluence on the concentration of NV centers was evaluated. The fluence was changed from about 1.8 J·cm⁻² to about 54 J·cm⁻².

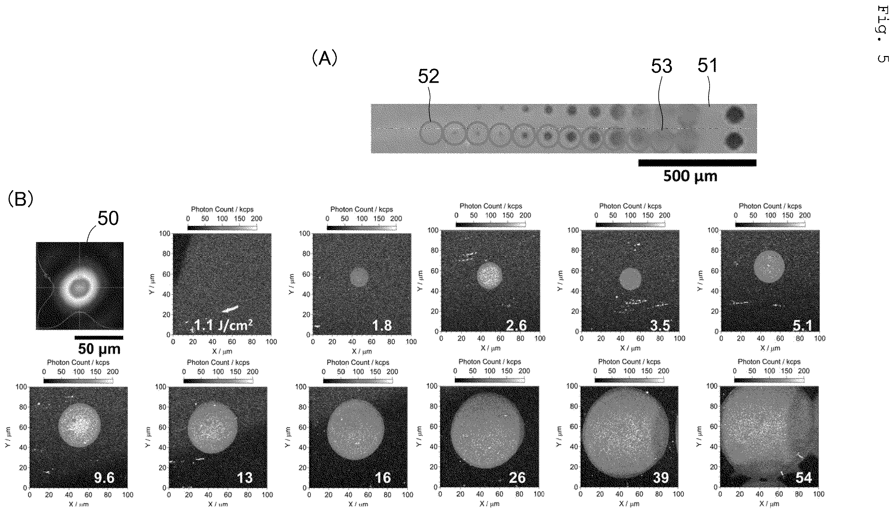

Fig. 5 shows the results of measuring the dependence of fluence in Example 2. Fig. 5(A) is a photographed image of a diamond substrate at a laser irradiation site. Fig. 5(B) shows confocal images at a laser spot on diamond. Fig. 5(B) shows laser profiles at an irradiation site side by side on the same scale as that of the confocal images of diamond, as indicated by reference numeral 50.

In Example 2, the fluence was first set to about 1.1 J·cm⁻², and NV centers were formed at the region indicated by reference numeral 52 in Fig. 5(A). Thereafter, while the fluence was changed, NV centers were formed one after another with the laser irradiation site being slid on a diamond substrate 51 toward the right in the figure. Eventually, NV centers were formed at the region indicated by reference numeral 53 in Fig. 5(A) with the fluence at about 54 J·cm⁻². In Fig. 5(B), the confocal image in which the fluence is about 1.1 J·cm⁻² corresponds to the region indicated by reference numeral 52 in Fig. 5(A). In Fig. 5(B), the confocal image in which the fluence is about 54 J·cm⁻² corresponds to the region indicated by reference numeral 53 in Fig. 5(A). In the laser profile indicated by reference numeral 50, the shape of the focal region was substantially circular, and the diameter of the focal region was about 24 um in full width at half maximum (FWHM), with the area of the focal region being about 452 µm².

The measurement results shown in Fig. 5 were analyzed. Referring to Fig. 5(B), a threshold for fluence at which fluorescence intensity increases was confirmed to be present within the range of fluence from about 1.1 J·cm⁻² to about 1.8 J·cm⁻². The fluence at which fluorescence intensity reaches the maximum value was about 9.6 J·cm⁻².

Referring to Fig. 5(B), the size of the focal region (laser spot) was compared with the size of the light-emitting region in each confocal image. When the fluence was about 5.1 J·cm⁻² or greater, the light-emitting region in the confocal images increased more widely than the focal region, indicating that NV centers were formed over a larger region than the focal region. The increase in light-emitting region in confocal images was also confirmed even when the fluence was at a maximum of about 54 J·cm⁻².

As shown in the measurement results in Fig. 5, NV centers were confirmed to form in diamond when diamond is irradiated with a convergent beam of femtosecond pulsed laser with a fluence equal to or above a threshold present within the range of about 1.1 J·cm⁻² to about 1.8 J·cm⁻². The area of the focal region at this time was about 452 µm² in full width at half maximum (FWHM), indicating the formation of NV centers in a large area of 10² µm² or greater in the focal region.

### Example 3

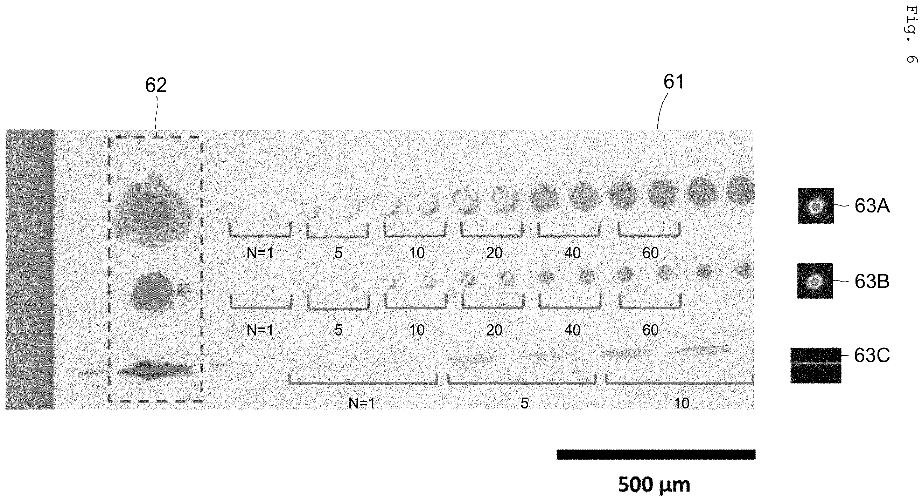

In Example 3, the effect of the frequency of pulse irradiation on graphitization of diamond was evaluated. NV centers were formed in diamond with different combinations of the shape of the focal region (laser spot) and fluence, while the frequency of pulse irradiation N was changed from 1 (one shot) to 60. Figs. 6 to 8 show the results.

Fig. 6 shows the state of a diamond substrate after NV centers were formed by varying the frequency of pulse irradiation in Example 3. The photograph of the diamond substrate 61 was taken before heat-assisted acid cleaning, described below, was performed.

In Fig. 6, the top row in the substrate 61 shows the surface of the substrate irradiated with pulsed light with a substantially circular laser spot at a fluence of about 20 J·cm⁻². The middle row in the substrate 61 shows the surface of the substrate irradiated with pulsed light with a substantially circular laser spot at a fluence of about 5 J·cm⁻². The bottom row shows the surface of the substrate irradiated with pulsed light with a substantially elliptical laser spot at a fluence of about 26 J·cm⁻². The alphabet N in the figure denotes the frequency of irradiation of pulsed light. In Example 3, irradiation with pulsed light was performed in two cycles with the same frequency of irradiation in each cycle. On the diamond substrate 61, there are pairs of laser spots; the laser spots in each pair were irradiated with pulsed light under the same conditions.

In Fig. 6, the region surrounded by a dashed line, indicated by reference numeral 62, is marking to identify the position on the substrate 61. At the right end of Fig. 6, laser profiles at an irradiation site are shown on the same scale as that of the photograph of the diamond substrate 61, as indicated by reference numerals 63A, 63B, and 63C. In the laser profiles indicated by reference numerals 63A and 63B, the shape of the focal region was substantially circular, and the area of the focal region was about 452 µm². In the laser profile indicated by reference numeral 63C, the shape of the focal region was horizontally elongated and substantially elliptical, and the area of the focal region was about 175 µm².

When the diamond substrate 61 shown in Fig. 6 was subjected to heat-assisted acid cleaning using an acid mixture of concentrated sulfuric acid and concentrated nitric acid, the dark sports almost disappeared except at the marking indicated by reference numeral 62. The surface of the substrate 61 was scraped to a greater degree as the frequency of pulse irradiation N was increased. From this result, it was inferred that the diamond was graphitized at the site irradiated with a greater frequency of pulse irradiation N.

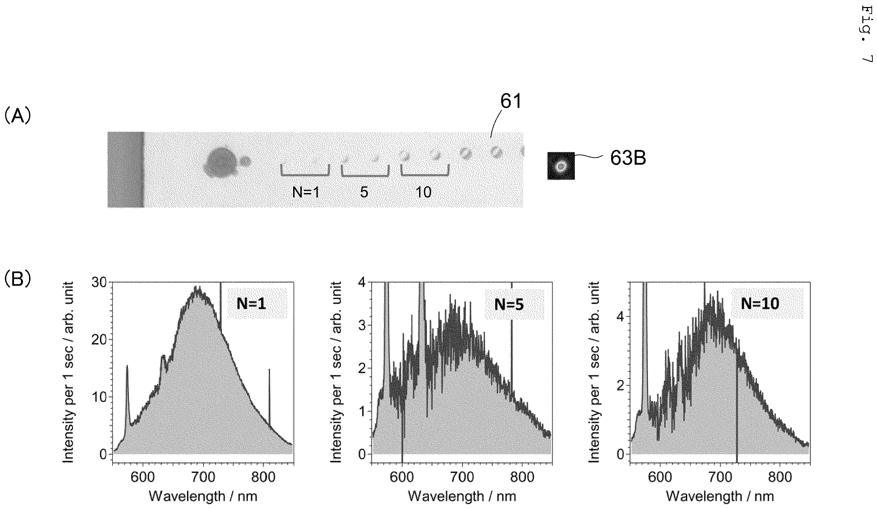

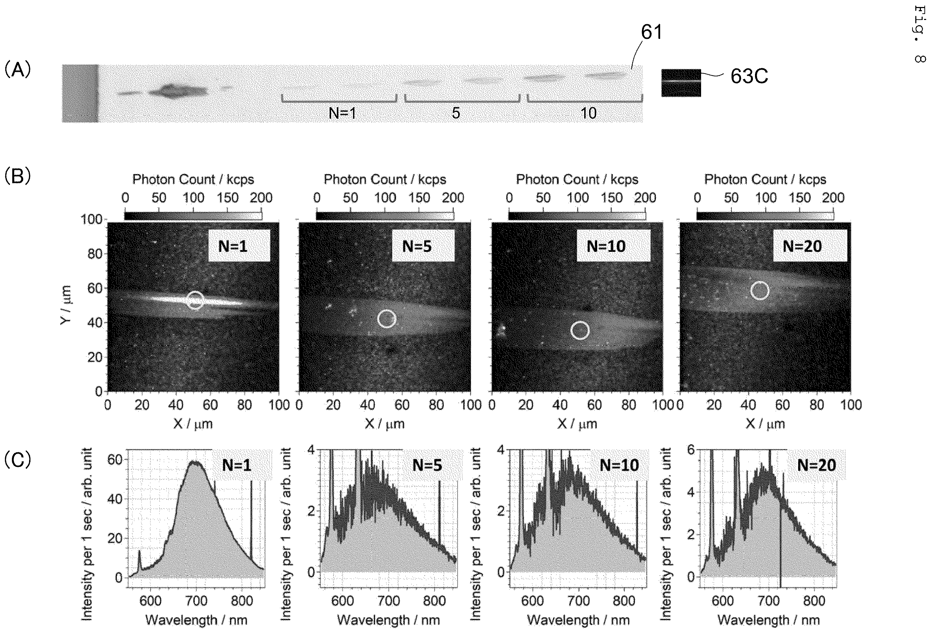

Figs. 7 and 8 show fluorescence spectra of graphitized diamond. Fig. 7(A) is an excerpt of part of the middle row in Fig. 6, showing the surface of the substrate irradiated with pulsed light with a substantially circular laser spot at a fluence of about 5 J·cm⁻². Fig. 7(B) shows fluorescence spectra at the center of the laser spots shown in Fig. 7(A).

The measurement results shown in Fig. 7 were analyzed. When the frequency of pulse irradiation N was one (one shot), the fluorescence spectrum had a shape unique to the NV center, as shown on the left of Fig. 7(B). Thereafter, as the frequency of pulse irradiation N was increased to 5 and to 10, the luminescence intensity shown on the vertical axis of the spectrum decreased with the shape of the fluorescence spectrum also being changed, as shown at the center and on the right of Fig. 7(B).

Fig. 8(A) is an excerpt of part of the bottom row in Fig. 6, showing the surface of the substrate irradiated with pulsed light with a substantially elliptical laser spot at a fluence of about 26 J·cm⁻². Fig. 8(B) shows confocal images at a laser spot on diamond. Fig. 8(C) shows fluorescence spectra at the center of laser spots shown in Fig. 8(A), and the fluorescence spectra are of the regions enclosed in a substantially circular shape by a solid line in the confocal images in Fig. 8(B).

The measurement results shown in Fig. 8 were analyzed. When the frequency of pulse irradiation N was one (one shot), the fluorescence spectrum had a shape unique to the NV center, as shown on the left of Fig. 8(C). Thereafter, as the frequency of pulse irradiation N was increased to 5, 10, and 20, the luminescence intensity shown on the vertical axis of the spectrum decreased with the shape of the fluorescence spectrum also being changed, as shown at the center and on the right of Fig. 8(C).

As shown in the measurement results in Figs. 6 to 8, when the frequency of pulse irradiation N was five or greater, the luminescence intensity (i.e., the concentration of NV centers) decreased due to the effect of graphitization of diamond. The results indicate that the frequency of pulse irradiation N is preferably within the range of 1 to 4, and more preferably 1 (one shot). In this Example, when NV centers were formed in diamond without graphitization, the area of the focal region was about 175 µm² to about 452 µm² in full width at half maximum (FWHM), indicating that NV centers were formed in a large area of 10² µm² or more of the focal region.

### Example 4

In Example 4, the concentration of the formed NV centers was calculated. The concentration was approximated from the luminescence intensity at a single NV center and the spatial resolution of a confocal fluorescence microscope.

First, the luminescence intensity of a single NV center was measured with a microscope. The laser power during the measurement was 100 µW.
- Luminescence intensity of a single NV center: 70 kcps The resolution of the microscope used for the measurement was the following:
- Resolution in plane direction: D_{FWHM} ≈ 400 nm
- Resolution in thickness direction: Z_{FWHM} ≈ 1500 nm The focal volume V was calculated assuming a rotating cylinder with a radius of D_{FWHM}/2 and a height of Z_{FWHM}.
- Focal volume: V ≈ 2 × 10⁻¹³ cm³

In the measurements shown in Examples 1 to 3, the maximum luminescence intensity from a focal region (laser spot) was roughly 500 kcps at the same laser power of 100 µW. Because the luminescence intensity of a single NV center was 70 kcps, 500 kcps/70 kcps ≈ 7. It was inferred that roughly 7 NV centers were formed in a focal volume on a converted value basis. Thus, the concentration of NV centers was approximated to be 7/(2 × 10⁻¹³ cm³) ≈ 3.5 × 10¹³ cm⁻³. As shown in Fig. 5(B) or other figures, the average spatial luminescence intensity was about 150 kcps; from this, it can be inferred that the concentration of NV centers formed in the diamond used for measurements in Examples 1 to 3 was roughly 10¹³ cm⁻³.

The depth direction of the diamond substrate on which the formation of NV centers was confirmed was about the same as the resolution of the microscope in the thickness direction. Thus, the thickness of the region in which NV centers were actually present would be thinner than the resolution of the microscope in the thickness direction, and the actual concentration would be higher than the approximate value. Current research reports that NV centers actually appear to be present only near the surface of diamond. In this case, the focal volume V would be even smaller, and the actual concentration would thus be higher than the approximate value.

### Example 5

In Example 5, attempts were made to form NV centers in a wider region on diamond in view of findings from Examples 1 to 4. A diamond substrate was irradiated with pulsed light in a vacuum created around the diamond substrate. The diamond substrate and laser optical system were placed in a vacuum chamber, and the pressure in the vacuum chamber was adjusted to about 5 × 10⁻² Pa by using a vacuum pump. The pulse energy of the laser was set to 166 mJ (about 0.2 J) with the fluence set to about 33 J/cm⁻². The focal region (laser spot) at a laser irradiation site on diamond was substantially circular in shape and about 1.1 mm in diameter in size. The frequency of pulse irradiation N was one (one shot).

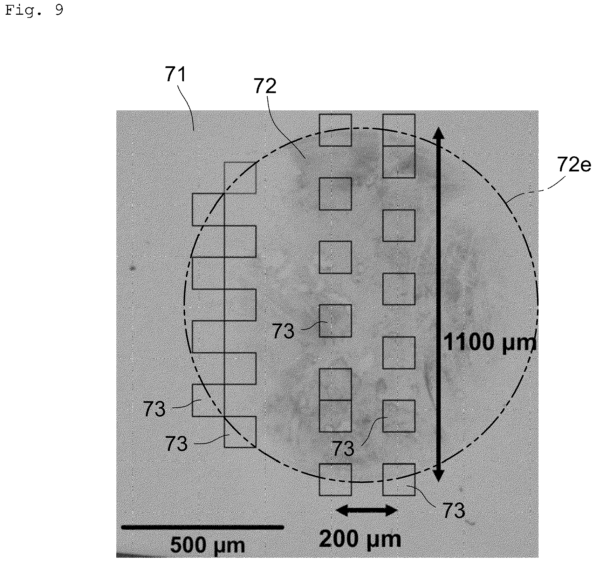

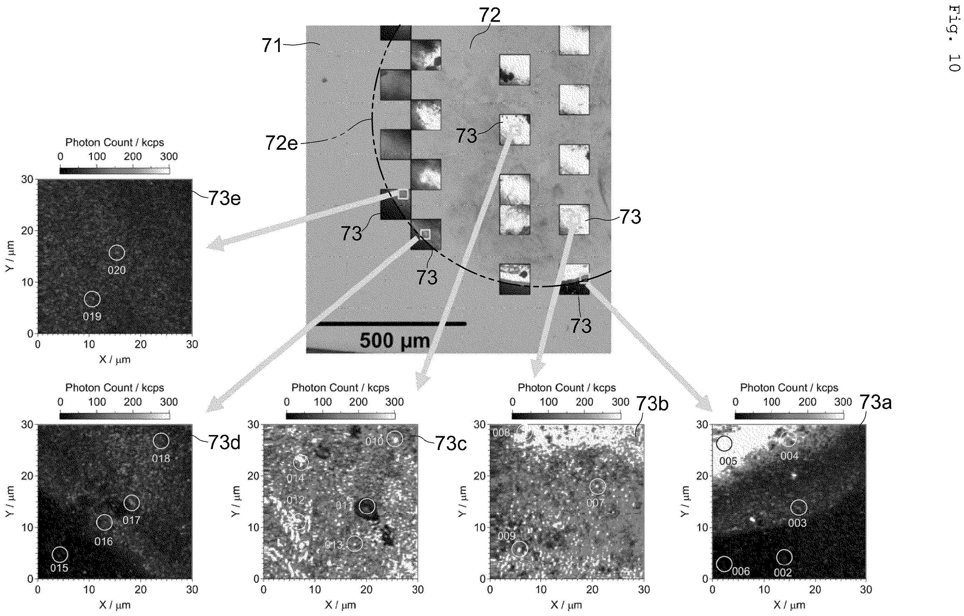

Fig. 9 shows the state of the diamond substrate after NV centers were formed in Example 5. The image of a diamond substrate 71 was captured after a heat-assisted acid cleaning. The substantially circular region indicated by reference numeral 72 is a focal region (laser spot) on the diamond substrate 71, and the double-dashed line indicated by reference numeral 72e is the outline (edge) of a focal region 72. Fluorescence intensity was observed for each of the divided rectangular regions indicated by reference numeral 73 (a total of 23 regions within the range shown in the figure). This is because a region of which fluorescence can be observed at one time with a confocal fluorescence microscope was about 100 µm square. Because of the optical system, the photograph of the diamond substrate 71 in Fig. 9 was symmetrical (mirror) with the confocal image shown in Fig. 10, the photograph of the diamond substrate 71 is shown as a mirror image.

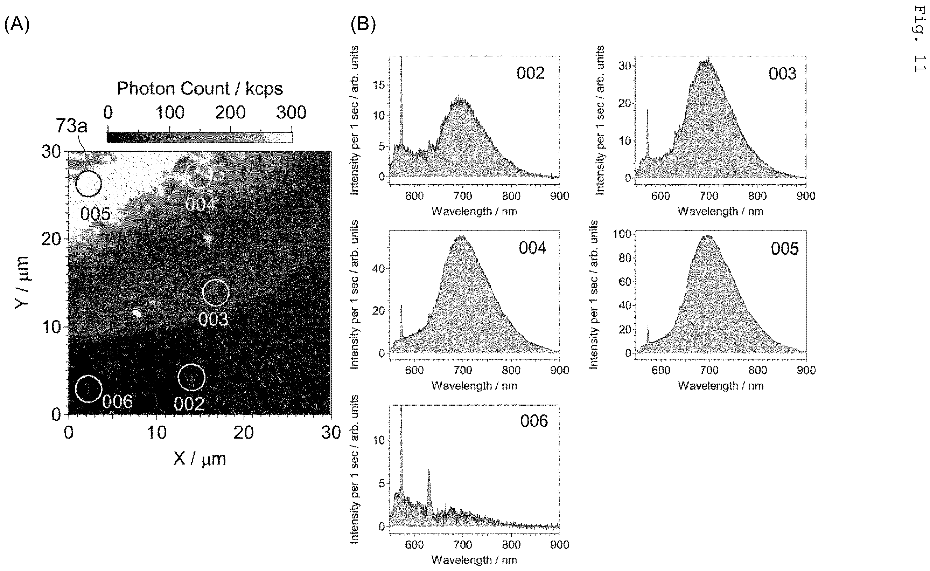

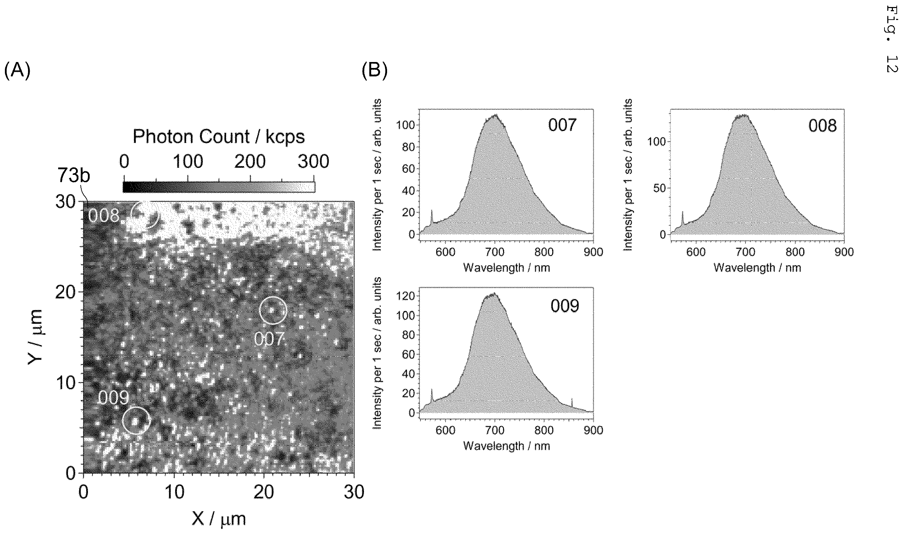

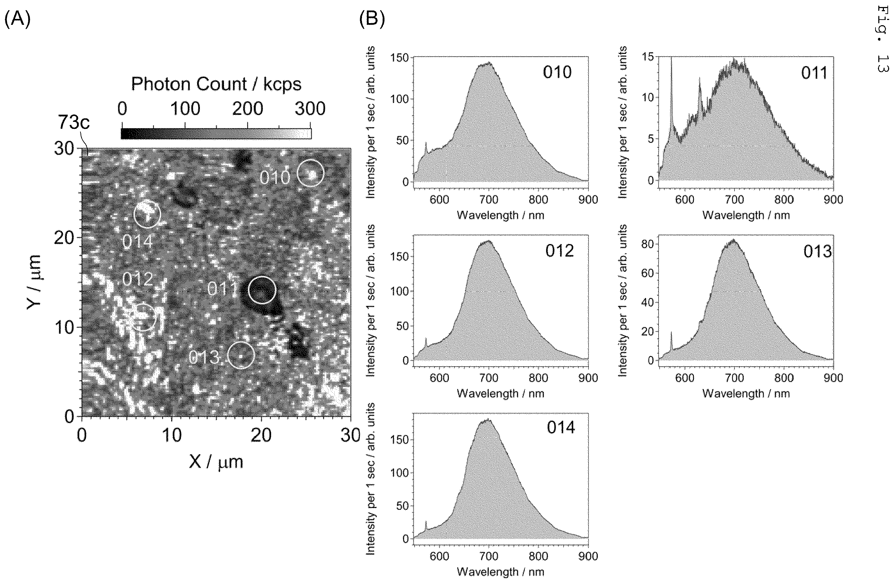

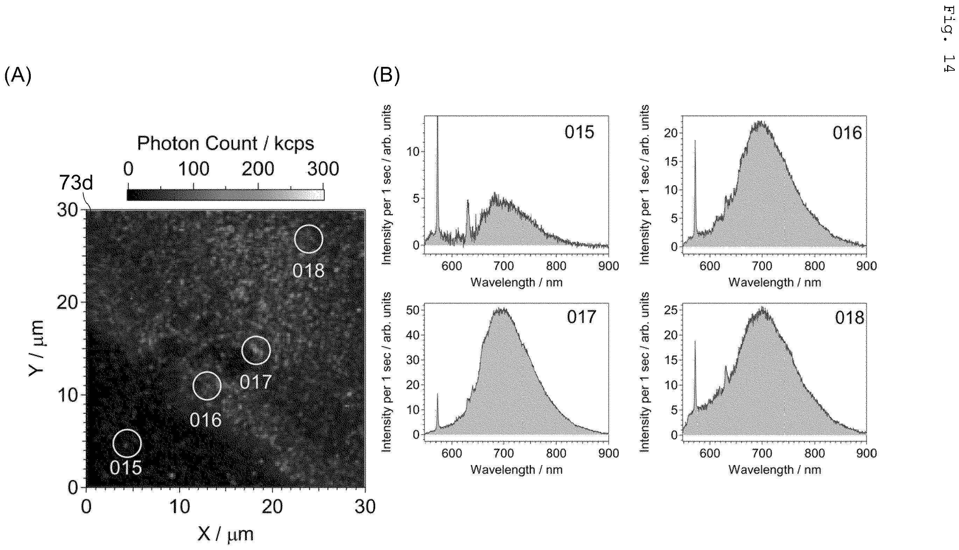

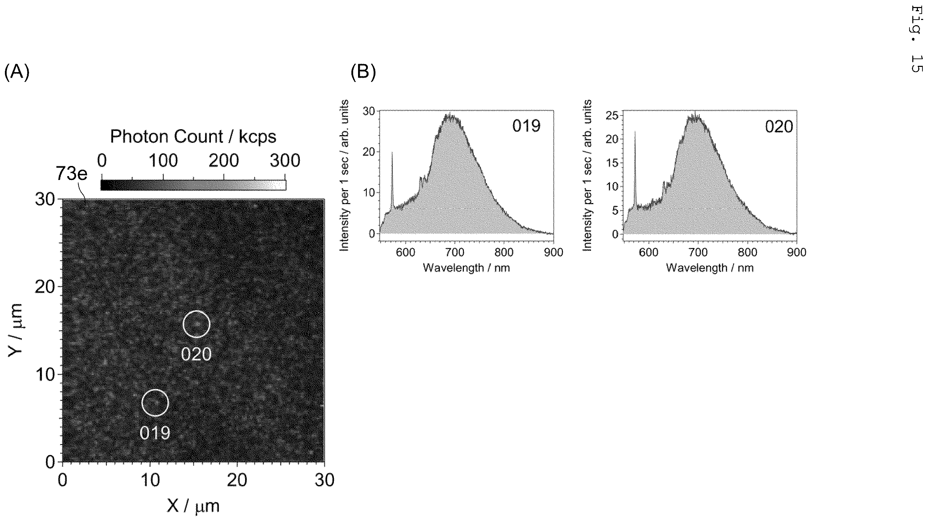

Fig. 10 shows a confocal image of diamond after NV centers were formed in Example 5, with the image superposed on the photograph of the diamond substrate shown in Fig. 9 so as to coincide with the photograph. The confocal images indicated by reference numerals 73a to 73e are enlarged images of part of the confocal images indicated by reference numeral 73. Fluorescence spectrum measurements were further performed for the regions enclosed by white circles with numbers 002 to 020 (number 001 being unassigned) in the confocal images 73a to 73e. Figs. 11 to 15 show the results of fluorescence spectrum measurements. In Figs. 11 to 15, (A) is an enlarged image of part of a confocal image, and (B) shows fluorescence spectra of the regions with numbers indicated in the image in (A). Table 1 shows the details of the regions indicated by numbers 002 to 020 in Figs. 11 to 15. To clearly show the region in which the luminescence intensity of fluorescence increased on the diamond substrate 71, the color scale of the luminescence intensity for all confocal images shown in Figs. 10 to 15 is standardized to a maximum of 300 kcps.

**Table 1**

| Region Number | Region | Region | Presence or |
|---|---|---|---|
| | Approximate Position | Specific Position | Absence of Luminescence |
| 002 | Near Border of Irradiation Region | Non-irradiation Region | Present |
| 003 | | Irradiation Region Border | |
| 004 | | Irradiation Region | |
| 005 | | | |
| 006 | | Non-irradiation Region | Absent |
| 007 | Near Center of Irradiation Region | Irradiation Region | Present |
| 008 | | | |
| 009 | | | |
| 010 | Near Center of Irradiation Region | Irradiation Region | Present |
| 011 | | | Luminescence is locally weak |
| 012 | | | Present |
| 013 | | | |
| 014 | | | |
| 015 | Near Border of Irradiation Region | Irradiation Region Border | Present |
| 016 | | | |
| 017 | | Irradiation Region | |
| 018 | | | |
| 019 | Near Border of Irradiation Region | Irradiation Region | Present |
| 020 | | | |

The measurement results shown in Figs. 10 to 15 and Table 1 were analyzed. In general, a fluorescence spectrum unique to NV centers were confirmed in a site in which the luminescence intensity was stronger in the region irradiated with pulsed light. In Example 5, the size of the focal region was set to about 1.1 mm in diameter on the millimeter order, which is larger than the micrometer order in Examples 2 and 3. Despite this, bright spots were confirmed in a wide region within such a large focal region 72. The position of the region in which bright spots were confirmed was not only near the center of the irradiation region, but also in the region near the boundary between the irradiation region and non-irradiation region, close to the edge 72e of the focal region 72, as shown in region numbers 003, 015, 016, etc. In such regions near the boundary, the formation of NV centers was confirmed. Looking at the region near the center of the irradiation region, luminescence intensity was found to be about 10 times stronger (about 800 kcps or greater) than the intensity due to a non-ensemble single NV center, especially in region number 010, 012, 014, etc. The region with region number 006 was a non-irradiation region, and no bright spots were identified. However, weak but bright spots were confirmed in the region with region number 002, which was a non-irradiation region though.

According to Example 5, NV centers were able to be formed over a wide region on diamond. The size of the region in which NV centers could be formed was as large as about 1.1 mm in diameter on the millimeter order, as shown in Figs. 9 and 10. In Example 5, the level of vacuum around the diamond substrate was set to about 5 × 10⁻² Pa. However, the level of vacuum around the diamond substrate should be sufficient as long as it can reduce the adverse effects due to collisions between laser light and molecules in the air or ionization. In other words, the pressure in the space around the diamond substrate is not limited to the pressure described in Example 5 (about 5 × 10⁻² Pa). It is sufficient if the pressure is lower than atmospheric pressure.

### Example 6

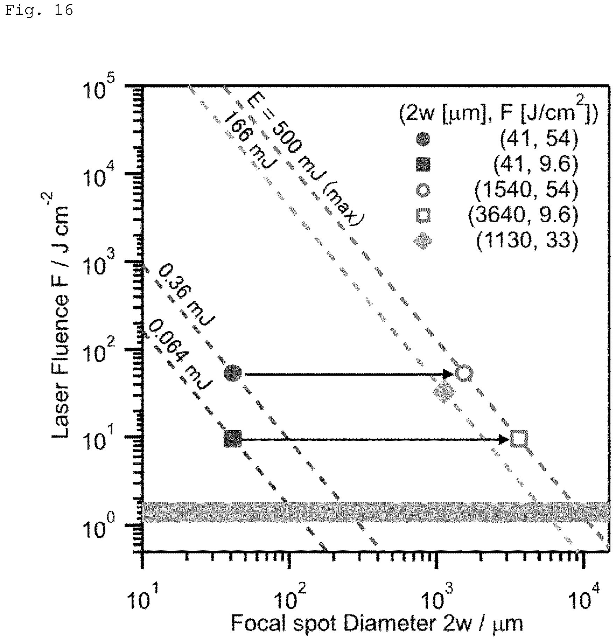

In Example 6, the relationship between the size of the focal region at a laser irradiation site and the laser fluence was examined for various kinds of pulse energy. Spatial distribution of laser pulse was assumed to be Gaussian. The shape of the focal region was assumed to be substantially circular. Fig. 16 shows a graph of the study results.

In the graph shown in Fig. 16, the solid black circle " solid black square "■," and solid black diamond "◆" indicate the actual measurement results. The solid black diamond "◆" in Fig. 16 indicates the measurement result of NV center formation in Example 5. The open circle "○" and open white square "□" indicate predicted measurement results, which are expected to be obtained when the measurement is performed at an output-limit pulse energy of 500 mJ in the laser (light source), while the fluence of the laser is maintained. The horizontal rectangular region shown at the bottom of the graph is the threshold for fluence to form NV centers and is based on the results of Example 2. In other words, it is inferred that NV centers can be formed if the value of fluence is present higher than the horizontal rectangular region shown at the bottom of the graph.

In view of the findings from Examples 2 and 5, the fluence of laser required to form an NV center on the millimeter order on diamond was studied. With focus on the actual measurement results indicated by the solid black square "■," measurement was assumed with a pulse energy ranging from 0.064 mJ to 500 mJ along the arrow in the figure. As indicated by the open white square "□," the predicted diameter of the focal region was about 3.6 mm (about 3640 pm) on the millimeter order, and the predicted diameter of fluence required to form an NV center was about 9.6 J/cm⁻². The predicted measurement values indicated by the open white square "□" were higher than the horizontal rectangular region shown at the bottom of the graph; thus, it was inferred that NV centers could be formed based on the results of Example 2.

From the above, it was inferred that the fluence of the laser that can form NV centers in a large region on the millimeter order is not limited only to about 33 J/cm⁻² (solid black diamond "◆"), which is illustrated in Example 5. In view of the findings from Examples 5 and 2, it was inferred that even a fluence of about 9.6 J/cm⁻² (solid black square "■") could enable the formation of NV centers in a large region on the millimeter order.

The present invention enables the efficient formation of vacancy defects in diamond. In the past, it was not easy to form NV centers in diamond without graphitizing diamond, and it was difficult to form NV centers in diamond efficiently. The present invention enables the efficient formation of highconcentration NV centers in a large region of diamond without graphitizing the diamond.

The area of the diamond in which NV centers are formed is about 175 µm² to about 452 µm² in full width at half maximum (FWHM); NV centers can be formed in a wide region of 10² µm² or more. Depending on the value of fluence, NV centers can be formed in a region wider than a focal region (laser spot). Furthermore, when diamond is irradiated with pulsed light from a laser, the pressure of the space around the diamond can be set to lower than atmospheric pressure to allow NV centers to form in a wide region on the millimeter order.

The frequency of pulse irradiation in forming NV centers is in the range of one to four, and more preferably one (one shot). This allows the formation of NV centers in diamond while preventing the graphitization of diamond.

In the present invention, the shape of the focal region can also be controlled to be substantially elliptical. An elliptical focal region allows NV centers to efficiently form in a wide region by sweeping the focal region by the present invention, and allows multiple elements to be cut out of a diamond substrate when pieces of diamond having NV centers are cut from the diamond substrate and mounted as elements of a quantum sensor. This improves productivity in the manufacture of elements.

The present invention also enables the formation of NV centers in diamond without annealing the diamond after irradiating the diamond with pulsed light of a laser. Eliminating the need for an annealing step makes it possible to use a lowtemperature process in the industrial production of quantum sensor elements including NV centers, and allows quantum sensor elements to be manufactured at room temperature in air.

Another method for forming NV centers in diamond is, for example, irradiating diamond with a high-energy electron beam on the order of MeV. However, such an electron-beam irradiation method has problems on an industrial scale, such as the radiation of X-rays during electron-beam irradiation, which results in limited facilities for forming NV centers and high manufacturing costs. However, the method for forming NV centers by irradiating diamond with pulsed light of a laser according to the present invention does not involve X-ray radiation and allows the formation of NV centers in a relatively large number of facilities as compared with the electron-beam irradiation method.

### Other Embodiments

Although the present invention is described above with reference to a particular embodiment, the invention is not limited to the above embodiment.

In the embodiment above, diamond is used as the sample 9, and a nitrogen-vacancy center, called "NV center," is formed as a color center, inside the diamond. However, the color center formed inside diamond is not limited to NV centers. Instead of NV centers, silicon-vacancy centers or germanium-vacancy centers may be formed inside diamond.

In the embodiment above, the pulsed light 2 output from the laser 1 has a pulse width in the time order of femtoseconds. However, the pulse width of the laser for irradiation to modify diamond is not limited to the time order of femtoseconds. As long as NV centers can be formed in diamond, diamond may be irradiated with a laser beam with a pulse width on the temporal order of, for example, attoseconds (10⁻¹⁸ seconds), which is shorter than femtoseconds (10⁻¹⁵ seconds). The peak power of a pulsed laser is calculated by dividing pulse energy (unit: J) by pulse width (unit: s). Thus, if pulse energy is constant, then as the pulse width of the pulsed light 2 becomes even shorter than the temporal order of femtoseconds, the peak power of the laser 1 also increases more.

The concentration of nitrogen impurities contained in the sample 9 is not limited to the concentration described in the embodiment above. For example, the concentration of nitrogen impurities in synthetic diamond may be less than the concentration described above (e.g., less than about 1 ppm) in the application in quantum sensors, and the synthetic diamond for use is not limited to type Ib, and may be type IIa. The synthetic diamond for use may also have a plane orientation other than [001].

### Description of the Reference Numerals

1 laser (optical source)
2 pulsed light
3 light-collecting element
4 aperture
5 total-reflection mirror
8 stage
9 sample
10 vacancy defect formation apparatus
20 measurement system
21 excitation light source
22 excitation light
23 dichroic mirror
24A objective lens
24B piezoelectric stage
25 fluorescence
26 photodiode
27 wire
28 microwave source
29 microwave detector
30 magnet
91 beam profiler

## Claims

1. A method for forming a vacancy defect in diamond, comprising the step of concentrating pulsed light from a pulsed laser to irradiate the diamond with the pulsed light,
wherein a fluence of the pulsed laser in a focal region on the diamond is 1.8 J·cm⁻² or more.

2. The method according to claim 1, wherein in the step of concentrating pulsed light from a pulsed laser to irradiate the diamond with the pulsed light, the diamond is repeatedly irradiated with one to four shots of a single beam of the pulsed light per cycle.

3. The method according to claim 1, wherein the fluence of the pulsed laser is 54 J·cm⁻² or less.

4. The method according to claim 1, wherein the focal region has an area of 175 µm² or more.

5. The method according to claim 1, further comprising the step of controlling a shape of the focal region.

6. The method according to claim 1, wherein the fluence of the pulsed laser is 5.1 J·cm⁻² or more.

7. The method according to claim 1, wherein
the fluence of the pulsed laser is 9.6 J·cm⁻² or more, and
the step of concentrating pulsed light from a pulsed laser to irradiate the diamond with the pulsed light is performed under a pressure in space surrounding the diamond lower than atmospheric pressure.

8. An apparatus for forming a vacancy defect in diamond, comprising
a pulsed laser, and
an optical system configured to concentrate pulsed light from the pulsed laser to irradiate the diamond with the pulsed light,
wherein a fluence of the pulsed laser in a focal region on the diamond is 1.8 J·cm⁻² or more.

9. The apparatus according to claim 8, wherein the optical system has an aperture configured to control a shape of the focal region.

10. A method for producing diamond having a vacancy defect, comprising
the step of preparing diamond, and
the step of forming a vacancy defect in the diamond according to the method of any one of claims 1 to 7.
